# EUROPEAN PATENT SPECIFICATION

(11) **EP 0 624 405 B1**
(45) Date of publication and mention of the grant of the patent: **12.03.1997**
(21) Application number: 94105507.1
(22) Date of filing: 08.04.1994
(51) Int. Cl.: B08B 3/12, B08B 7/00, H01L 21/00, H05K 3/26

(54) **Megasonic cleaning system using compressed, condensed gases**
Megaschallreinigungssysteme, die komprimierte, flüssige Gase verwenden
Système de nettoyage pour mégasons utilisant des gaz comprimés et condensés

(30) Priority: 12.04.1993 US 44684
(43) Date of publication of application: 17.11.1994
(73) Proprietor: Hughes Aircraft Company, Los Angeles, California 90080-0028 (US)
(72) Inventor: Stanford, Thomas B. Jr., San Pedro, California 90731 (US); Chao, Sidney C., Manhattan Beach, California 90266 (US)
(74) Representative: KUHNEN, WACKER & PARTNER

(56) References cited:
- EP-A- 0 583 653
- US-A- 4 618 263
- US-A- 5 213 619
- PATENT ABSTRACTS OF JAPAN vol. 15, no. 448 (E-1133) 14 November 1991 & JP-A-03 190 131 (IWATANI INTERNATL CORP) 20 August 1991
- DATABASE WPI Section EI, Week 9404, Derwent Publications Ltd., London, GB; Class U, Page 11, AN 94-034039 C04! & US-A-5 279 316 (PCT SYSTEMS INC) 18 January 1994
- DATABASE WPI Section Ch, Week 9334, Derwent Publications Ltd., London, GB; Class L, Page 03, AN 93-267829 C34! & JP-A-5 182 943 (IDEMITSU KOSAN CO LTD) 23 July 1993

## Description

### BACKGROUND OF THE INVENTION

### 1. Field of the Invention

The present invention relates to the use of megasonic energy (>110 to 2,000 Kilohertz) to clean substrates, and, more particularly, to a process employing liquefied gas, such as liquid carbon dioxide, in combination with megasonic energy to enhance the cleaning of a wide variety of substrates, including complex materials and hardware.

### 2. Description of Related Art

Ultrasonic cleaning has been utilized by industry for a number of years. In the conventional processes, the sonicating media are either organic solvents, or water and aqueous solutions, and ultrasonic energy (about 20 to 100 Kilohertz) is applied to the media to promote cavitation, i.e., the formation of bubbles and their subsequent collapse. Although adequate for the sonication cleaning, both types of solvents have disadvantages. Many substrates require a rigorous drying process following exposure to an aqueous medium, and this is often a time-consuming thermal excursion. The use of organic solvents as sonicating media presents the problem of chemical disposal and is subject to strict regulatory controls. An additional disadvantage relates to handling of the removed contaminant(s), whether organic or particulate. When the contaminant is a hazardous material, such as a radioactive particle, once in solution or suspension, the volume of the hazardous waste is substantially increased, and this presents an additional pretreatment/disposal problem.

In these conventional ultrasonic cleaning processes, sonic horns are often used to produce the sonic energy. In other processes, a cavitation nozzle may be used.

Liquid carbon dioxide (CO₂) is an inexpensive, nontoxic substance. The cleaning process utilizing liquid CO₂ is relatively simple, and contaminants taken up in liquid CO₂ are easily removed therefrom, such as by decompression of the liquid or by filtration or by a combination of the two. Other suitable liquefiable gases may be used.

Another type of cleaning process, utilizing phase shifting of dense phase gases, has been disclosed and claimed in U.S. Patent No. 5,013,366, issued to D.P. Jackson et al and assigned to the same assignee as the present application. The latter process employs a dense phase gas at or above the critical pressure. The phase of the dense phase gas is then shifted between the liquid state and the supercritical state by varying the temperature of the dense fluid in a series of steps between temperatures above and below the critical temperature of the dense fluid, while maintaining the pressure above the critical value. Examples of fluids include (1) hydrocarbons, such as methane, ethane, propane, butane, pentane, hexane, ethylene, and propylene; (2) halogenated hydrocarbons, such as tetrafluoromethane, chlorodifluoromethane, and perfluoropropane; (3) inorganics, such as carbon dioxide, ammonia, helium, krypton, argon, sulfur hexafluoride, and nitrous oxide; and (4) mixtures thereof. In alternative embodiments, the dense phase gas may be exposed to ultraviolet (UV) radiation during the cleaning process or ultrasonic energy may be applied during the cleaning process to agitate the dense phase gas and the substrate surface.

Ultrasonic cleaning is very effective for removing particulate as low as 1 to 5 micrometers in size. However, for particles below this range, the effectiveness of ultrasonics at 20 to 100 Kilohertz is poor and ultrasonic frequencies can be damaging to delicate substrates, such as silicon wafers. Further, in order to remove sub-micrometer particulates, scrubbing techniques are employed which are often harsh to the product and difficult to use consistently. Similarly, high pressure water jets can be harmful to the part being cleaned.

Current megasonic precision cleaning systems utilize aqueous based or organic solvent media, as described, for example, in U.S. Patent 5,062,898, issued to McDermott et al. Aqueous methods typically use surfactants, hydrogen peroxide/ammonium hydroxide or hydrochloric acid. These methods are expensive, require laborious drying techniques, use toxic/hazardous chemicals, and are environmentally undesirable. Compressed gas ultrasonic and supercritical fluid cleaning methods are environmentally sound and low-cost, but are not very effective for sub-micrometer particles.

Thus, a process for removing sub-micrometer particles from substrates is needed. Such a cleaning process would be simple and employ inexpensive, nontoxic cleaning media.

### SUMMARY OF THE INVENTION

In accordance with the invention, undesired sub-micrometer particulates are removed from a chosen substrate by a process comprising the steps of: (a) placing the substrate containing the undesired particulates in a cleaning chamber provided with (1) means for supporting the substrate in the cleaning chamber, (2) megasonic energy-producing transducer means attached to the means for supporting the substrate and oriented so as to emit megasonic energy parallel to the substrate surface to be cleaned, and (3) means for deflecting the energy so as to prevent the megasonic energy from destructively interfering with itself; (b) introducing into the cleaning chamber a fluid comprising (1) a liquefied gas, or (2) a mixture of liquefied gases, or (3) a liquefied gas containing a liquid modifier, the fluid formed by applying a pressure of about 600 to 3,000 pounds per square inch (42.2 to 210.9 Kg/cm²) at a temperature of about 50°C or less thereto, and contacting the substrate containing the undesired particulates with the fluid at a temperature below its critical temperature; and (c) exposing the fluid to the transducer means for a period of time sufficient to remove the undesired particulates from the substrate.

Liquid carbon dioxide (CO₂) is an inexpensive, nontoxic substance. The cleaning process utilizing liquid CO₂ is relatively simple, and contaminants taken up in liquid CO₂ are easily removed therefrom, such as by decompression of the liquid or by filtration or by a combination of the two. Other suitable liquefiable gases, gas mixtures, or gases modified with other liquids or gases may be employed in the practice of the invention.

The present invention employs ultra high frequency vibrations of greater than 110 to 2,000 Kilohertz to produce a megasonic cleaning system. Megasonic cleaning is typically performed in fluids which are normally liquids under ambient conditions. This invention allows megasonic cleaning to be performed in compressed condensed gases.

The invention permits the removal of sub-micrometer particles to be performed with high efficiency using compressed condensed fluids. Furthermore, this invention allows the use of environmentally safe cleaning systems as replacements for current precision cleaning practices. Also, this invention precludes a final drying step, which is very time and energy consuming, as is currently used in many methods which require the use of water. The present invention provides for a highly effective, inexpensive, and environmentally sound means of cleaning.

### BRIEF DESCRIPTION OF THE DRAWINGS

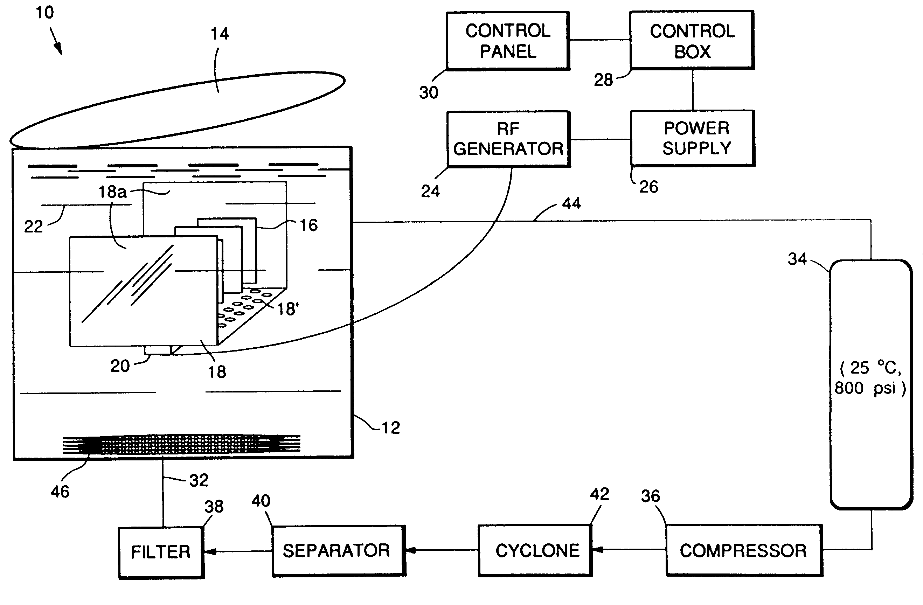

The sole Figure is a schematic diagram of megasonic cleaning apparatus useful in the practice of the invention.

### DESCRIPTION OF THE PREFERRED EMBODIMENTS

The present invention is applicable to many processes involving supercritical fluids such as carbon dioxide for precision cleaning, extractions, particulate removal, and degreasing. The present invention is applicable for general particulate removal processes, but is most useful when high-level precision cleaning is required. Exemplary applications include cleaning during manufacture of contact lenses, silicon wafers, magnetoresistive heads, and other solid state devices, precision mirrors and optical lenses, and optical parts for lasers.

The prior art ultrasonic cleaning process is a very effective technique for removing particulate from parts requiring precision cleaning and has been used in conjunction with many organic and aqueous solvents to remove organic contamination as well. Ultrasonic cavitation works by forming vacuum bubbles which, upon implosion, release high energies which dislodge and displace particulates in the vicinity of the collapsing bubble. However, surface energies are such that with most surface types, for particles below 1.0 micrometer, ultrasonic cavitation is not sufficient to remove this particulate with high efficiency.

Megasonic energy is more efficient than ultrasonic cleaning for sub-micrometer particulate removal because it functions via a different mechanism. Because megasonic energy occurs at higher frequencies than ultrasonic energy, the pressure wave that forms generates a pulse so rapidly that the vacuum bubbles do not have time to form. Consequently, megasonic energy consists of a series of pressure waves. When applied parallel to a surface, this wave dislodges particulates, usually by first allowing a thin film of the solvent medium to form between the particulate and the surface, thereby reducing the attraction between the surface and the particulate and facilitating removal of the particle.

Obviously, many different solvents may be used in this process. However, when compressed, condensed gases are used, several advantages are realized. First, no drying or separate solvent removal step is required. The process of removing the part from the vessel results in the complete elimination of the condensed gas "solvent". Also, because the solvent becomes a gas at ambient conditions, it is conveniently recycled and the need to dispose of waste solvent is eliminated. Finally, when using condensed gases such as CO₂, a very cost effective and environmentally sound method is provided. Furthermore, when combined with sequential supercritical phase cleaning, a convenient and complete cleaning process for particulate and organic contamination removal can be obtained.

Similarly, with a modified compressed gas, described in further detail below, both the compressed gas and the entrained liquid modifier are quickly removed from the part. This fluid is treated within the separator to isolate the modifier and contaminants and recycle the compressed gas. The separated modifier is then either recycled or disposed of as waste.

The fluid used in the practice of the present invention is chosen to be a gas, or mixture of gases, or other fluids, which can be liquefied under moderate conditions of pressure and temperature, typically, for practical purposes, a pressure of about 600 to 3,000 pounds per square inch (42.2 to 210.9 Kg/cm²) and a temperature of about 50°C or less. In addition, for practical purposes, it is desirable that the fluid is also non-toxic, non-flammable, and does not cause any damage to the environment.

Gases which are suitable for practicing the present invention include, but are not limited to, carbon dioxide, nitrogen, nitrous oxide (N₂O), sulfur hexafluoride (SF₆), and xenon, with carbon dioxide being most preferred. In the following discussions, carbon dioxide is used as an example of one gas which may be used in practicing the present invention, but it is to be understood that the invention is not so limited.

Carbon dioxide is an unlimited, inexpensive, nontoxic, and easily liquefiable natural resource. Once liquefied, it offers a good, low viscosity sonicating medium, at relatively low pressures (about 600 to 1,040 pounds per square inch, or about 42.2 to 73.1 Kg/cm²) and mild temperatures (about 10° to 30°C). These values are below the critical pressure of 75.3 Kg/cm² and the critical temperature of 32°C for CO₂.

When a liquefiable gas is used with modifiers, typically a small percentage (less than about 50 vol/vol percent) of a condensed phase solvent, or modifier, is added to the bulk compressed gas. These modifiers are mixed with the compressed gas to form a non-flammable, non-toxic mixture. The modifiers change the critical point of the mixture so that higher pressures (up to about 3,000 pounds per square inch, or 210.9 Kg/cm²) and temperatures (up to about 50°C) can be used, which provides improved sonication. In addition, the modifiers change the chemical properties of the condensed gas to improve the solubility properties of the mixture. The modifier or modifiers used depend on the contaminant being removed. For removing polar organic contaminants, a solvent such as iso-propanol or acetone is employed. For removing polar inorganic contaminants, water is desirably employed. For removing low molecular weight non-polar organic (C₆ to C₁₈) contaminants, a solvent such as hexane may be used. For removing high molecular weight non-polar organic (>C₁₈) contaminants, a solvent such as kerosene may be used.

The megasonic energy required in the practice of the present invention may be produced by means such as a high frequency transducer that produces energy having a frequency of greater than 110 to 2,000 Kilohertz, and preferably about 800 to 1,000 Kilohertz. Such megasonic energy-producing transducers are commercially available.

A schematic of the apparatus used in practicing the present invention is shown in the sole Figure, which depicts an extractor/cleaning vessel **10**. The cleaning vessel **10** comprises a walled cleaning chamber **12** formed of an appropriate material, such as stainless steel, and provided with walls of a sufficient thickness to withstand the pressures employed in the process. The cleaning chamber **12** is provided with a lid **14**, also of such sufficient thickness.

Parts **16** to be cleaned are placed in the cleaning chamber **12**. The parts **16** are supported on a fixture **18** that serves to support both the part and a high frequency transducer **20**. The transducer **20** and parts **16** are oriented so that the megasonic wave that is produced is parallel to the surface of the part being cleaned. The fixture **18** is further provided with deflector means **18a** which prevent deflection of the megasonic energy back on itself, which would otherwise result in undesirable destructive interference, and thus reduced cleaning efficiency. The fixture **18** is also provided with openings **18'** in the bottom thereof, to permit draining of cleaning fluid from the fixture.

Processing begins by flushing the parts **16** with a liquid or supercritical fluid; then the chamber **12** is filled with liquid **22** and the transducer **20** is energized. Megasonic energy is supplied, for example, at 800 to 1,000 Kilohertz through the transducer **20**, such as a quartz transducer, which is controlled by a radio frequency (RF) generator **24** and power supply **26**. The power supply **26** is controlled through a control box **28** by means of a control panel **30**. The transducer **20**, RF generator **24**, power supply **26**, control box **28**, and control panel **30** are conventional items in megasonic energy-producing systems, and are commercially available.

Cleaning is typically performed for a few minutes without fluid circulation, and then clean fluid is quickly pumped through the chamber **12**, as described below, to remove the liberated particles.

Liquid **22** is provided to the chamber **12** through inlet means **32** from a reservoir **34** by means of a compressor or high pressure pump **36**. The liquid **22** is purified before use by filter **38** and separators **40**, **42** to remove particulate and organic contamination. Cyclone separator **42** removes large particulates (i.e., >100 µm), separator **40** removes organics, and filter **38** removes small particulates (i.e., 0.1 to 100 µm).

After cleaning, the liquid **22** exits from the chamber **12** by outlet means **44** and may be vented (not shown) or recycled back to the liquid reservoir **34**, as shown in the Figure.

Additionally, the cleaning chamber **12** may incorporate an internal heating/cooling coil **46** for controlling the temperature of the liquid **22**. In addition, a thermocouple (not shown) and a pressure gauge (or pressure transducer) (not shown) may be used to determine and control the temperature and pressure, respectively, in the cleaning chamber **12**. The cleaning chamber **12** may optionally have ports (not shown) to accommodate an external liquid level indicator (not shown) to indicate the level of the liquid **22** in the chamber **12**.

The parameters of sonication include the temperature and pressure of the fluid, such as liquid CO₂, and the sonicating conditions (frequency, time of sonication, etc.). The carbon dioxide or other gas or gas mixture or modified gas mixture must be in the liquid state. Hence, the temperature and pressure must be above the triple point (e.g., -57°C and 75 pounds per square inch, or 5.3 Kg/cm² for CO₂). Furthermore, the temperature must be below the critical temperature. The pressure may be either above or below the critical pressure.

For pure compressed gases, the critical pressure and temperature will be that of the gas used. For gas mixtures, the critical pressure and temperature will vary as a function of the mixture used (i.e., the specific nature and amount of the added gases or modifiers).

Preferably, the temperature ranges from about 18°C to just below the critical value for carbon dioxide, since the cleaning performance decreases below 18°C and above the critical value. Under equilibrium conditions, the pressure is fixed by the temperature, and thus preferably ranges from about 820 pounds per square inch (about 57.7 Kg/cm²) to just below the critical value for carbon dioxide.

The present process does not appear to depend on the particular megasonic frequency, and any of the commercially available apparatus may be used. Commercial ultrasonic generators typically operate at a frequency of about 800 to 1,000 Kilohertz, and these generators are advantageously employed in the practice of the present invention.

In operation, the parts **16** to be cleaned are introduced into the cleaning chamber **12**. Liquid CO₂ is then introduced into the cleaning chamber **12** through inlet **32**, as described above, under controlled conditions of flow rate, temperature, and pressure, as are known in the art. The liquid CO₂ is introduced at a temperature below the critical value for CO₂, as indicated above. Temperature can be controlled either by filling the chamber with pre-heated or cooled liquid CO₂ or by heating or cooling the chamber. Normally, the pressure will be fixed by the vapor pressure of CO₂ at a given temperature. It may be desirable in some cases to provide increased pressure in order to produce more vigorous sonication. To provide this additional pressure, a non-condensible gas (i.e., a gas which is not liquefied at the temperature at which the process of the present invention is conducted), such as nitrogen, may be introduced to the chamber by means of a compressor or a high pressure gas cylinder. Additional pressure may also be provided by filling the chamber completely full of liquid CO₂ and controlling the pressure of the inlet or outlet stream.

Sonication is then applied at the above-indicated frequency. The time of sonication is dependent on the particular sample being cleaned and the nature of the undesired material, or contaminant, to be removed. Some samples cannot be exposed to sonication for prolonged periods of time. On the other hand, some undesired materials take longer to remove than others. Simple experimentation will determine optimum times for sonication to remove substantially all contaminants. In general, sonication for at least about 1 minute is expected to remove a substantial amount of the contaminants, with a maximum of about 1 hour possibly required in some cases. However, under certain circumstances, even further sonication may be required, for the reasons stated above.

At the completion of the sonication cycle, a liquid CO₂ purge is initiated. Following the purge step, the chamber can be decompressed for removal of the sample, or, the cleaning step can be repeated as required. To determine if the part is sufficiently clean, spot checking by surface analysis or by extraction analysis may be performed or measurements of particulate concentration may be made, as appropriate.

In a further embodiment of the invention, the parts **16** to be cleaned also have organic contaminants in addition to particulate contaminants. The parts **16** are loaded in the cleaning chamber **12**, which is then closed and purged with CO₂ gas for a predetermined period of time. The chamber is pressurized and heated to a suitable supercritical level which is determined by the specific contaminants and substrates, to remove the bulk of the organic contamination. Specifically, both the pressure and temperature are adjusted to exceed the critical values for CO₂. The sample is exposed to CO₂ in the dense, or supercritical, phase for a period of time which is sufficient to dissolve the organic contaminants which are soluble in supercritical CO₂ (referred to herein as "soluble contaminants").

The temperature is then reduced below its critical value to liquefy the CO₂. Sonication of the liquid CO₂ is initiated to remove particulates, as described above. The steps of treatment by sonication and treatment with supercritical CO₂ may be repeated as many times as are required to clean the sample.

In another embodiment of the invention, the parts to be cleaned which have organic contaminants as well as particulate contaminants are treated in accordance with the process of the present invention and are subsequently subjected to dense phase gas cleaning by repressurizing and reheating the CO₂ to supercritical conditions. This two-step process is useful, for example, to remove compact mixtures of particulates and soluble contaminants. The steps of treatment with supercritical CO₂ and treatment by sonication may be repeated as many times as required to clean the sample.

In yet another embodiment of the present invention, a closed loop, recirculating liquid CO₂ regenerating system is employed, in which the removed contamination (be that organic or particulate) can be readily separated from the megasonic transmitting medium. This can be accomplished either by decompression, filtration, or a combination of both. By the decompression of the liquid CO₂, gaseous CO₂ is formed and the contaminants separate out in a concentrated form that allows for easy disposal. The clean gaseous CO₂ remaining is then recompressed to the liquid state and the clean liquid CO₂ is recirculated to the cleaning chamber **12**. To accomplish this process, the liquefied gas containing the contaminants is transported out of the chamber **12** through outlet means **44** to a treatment unit (not shown). In the treatment unit, the contaminated liquefied gas is decompressed and/or filtered as indicated above. The clean liquid CO₂ is then transported by tubing (not shown) into chamber **12** through inlet means **32**.

## Claims

1. A process for removing undesired sub-micrometer particulates from a major surface of a chosen substrate (**16**) comprising the steps of:
(a) placing said substrate (**16**) containing said undesired particulates in a cleaning chamber (**12**) provided with (1) means (**18**) for supporting said substrate in said cleaning chamber, (2) megasonic energy-producing transducer means (**20**) attached to said means (**18**) for supporting said substrate and oriented so as to emit megasonic energy parallel to said major surface of said substrate (**16**), and (3) means (**18a**) for deflecting said megasonic energy so as to prevent said megasonic energy from destructively interfering with itself;
(b) introducing into said cleaning chamber a fluid (**22**) selected from the group consisting of (1) a liquefied gas, (2) a mixture of liquefied gases, and (3) a liquefied gas containing a liquid modifier, said fluid (**22**) formed by applying a pressure of about 600 to 3,000 pounds per square inch (42.2 to 210.9 Kg/cm²) at a temperature of about 50°C or less thereto, and contacting said substrate (**16**) containing said undesired particulates with said fluid (**22**) at a temperature below the critical temperature of said gas; and
(c) at least one time exposing said fluid (**22**) in said cleaning chamber (**12**) to said megasonic energy transducer means for a period of time sufficient to remove said undesired particulates from said substrate (**16**).

2. The process of Claim 1 wherein said gas is selected from the group consisting of carbon dioxide, nitrogen, nitrous oxide, sulfur hexafluoride, and xenon and mixtures thereof.

3. The process of Claim 1 wherein said substrate has at least one contaminant thereon selected from the group consisting of polar organic contaminants, polar inorganic contaminants, low molecular weight non-polar organic contaminants, and high molecular weight non-polar organic contaminants and said liquid modifier is selected from the group consisting of (a) iso-propanol and acetone for treating said polar organic contaminants, (b) water for treating said polar inorganic contaminants, (c) hexane for treating said low molecular weight non-polar organic contaminants, and (d) kerosene for treating said high molecular weight non-polar organic contaminants.

4. The process of Claim 1 wherein said substrate (**16**) has organic contaminants thereon and further comprising the step of, prior to contacting said substrate (**16**) containing said undesired material with said fluid (**22**), contacting said substrate (**16**) with said gas in the dense phase at a pressure above the critical pressure of said gas and at a temperature above the critical temperature of said gas for a period of time sufficient to remove said organic contaminants which are soluble in said gas in said dense phase.

5. The process of Claim 1 wherein said substrate (**16**) has organic contaminants thereon and further comprising the step of, after said exposing step, contacting said substrate (**16**) with said gas in the dense phase at a pressure above the critical pressure of said gas and at a temperature above the critical temperature of said gas for a period of time sufficient to remove said organic contaminants which are soluble in said gas in said dense phase.

6. The process of Claim 1 further comprising the step of, following said exposing step, treating said fluid (**22**) containing said undesired particulates to remove said undesired particulates and returning said treated fluid (**22**) to said cleaning vessel (**12**).

7. The process of Claim 1 wherein said gas is carbon dioxide and wherein said temperature ranges from about 10° to about 30°C and said pressure ranges from about 600 to 1,040 pounds per square inch (about 42.2 to 73.1 Kg/cm²).

8. The process of Claim 1 wherein said exposing is carried out for a period of time of at least about 1 minute.

9. The process of Claim 1 wherein said transducer means (**20**) provides megasonic energy with a frequency ranging from greater than about 110 to 2,000 Kilohertz.

10. Apparatus (**10**) for removing said undesired sub-micrometer particulates from said major surface of said chosen substrate (**16**) in the process of Claim 1 comprising:
(a) said chamber (**12**) for containing said fluid (**22**) and said substrate (**16**) containing said undesired particulates, said chamber (**12**) provided with (1) said means (**18**) for supporting said substrate (**16**) in said cleaning chamber (**12**), (2) said megasonic energy-producing transducer means (**20**), and (3) said means (**18a**) for deflecting said megasonic energy;
(b) pressure control means connected to said chamber (**12**) for controlling the pressure within said chamber (**12**);
(c) temperature control means (**46**) connected to said chamber (**12**) for controlling the temperature within said chamber (**12**);
(d) inlet means (**32**) in said chamber (**12**) for introducing said fluid (**22**) into said chamber (**12**); and
(e) outlet means (**44**) in said chamber (**12**) for removing said fluid (**22**) from said chamber (**12**).

## Patentansprüche

1. Verfahren zum Entfernen unerwünschter submikroner Partikel von einer Hauptoberfläche eines ausgewählten Substrats (16), das die folgenden Schritte aufweist:
(a) Anordnen des Substrats (16), das die unerwünschten Partikel enthält, in einer Reinigungskammer (12) mit: (1) einer Einrichtung (18) zum Tragen des Substrats in der Reinigungskammer, (2) einer Megaschallenergie erzeugenden Übertragereinrichtung (20), die an der Einrichtung (18) zum Tragen des Substrats befestigt ist, und die so ausgerichtet ist, daß sie die Megaschallenergie parallel zu der Hauptoberfläche des Substrats (16) emittiert, und (3) einer Einrichtung (18a) zum Ablenken der Megaschallenergie, so daß eine destruktive Interferenz der Megaschallenergie mit sich selber verhindert wird;
(b) Einbringen eines Fluides (22) in die Reinigungskammer, die aus einer Gruppe ausgewählt wird, die aus (1) einem verflüssigten Gas, (2) einem Gemisch aus verflüssigten Gasen, und (3) einem verflüssigten Gas, das einen flüssigen Modifizierer enthält, besteht, wobei das Fluid (22) durch Verwenden eines Drucks von ungefähr 600 bis 3,000 Pfund pro Quadratinch (42,2 bis 210,9 Kg/cm²) bei einer Temperatur von ungefähr 50°C oder weniger ausgebildet wird, und wobei das Substrat (16), das die unerwünschten Partikel enthält, mit dem Fluid (22) bei einer Temperatur unterhalb der kritischen Temperatur des Gases kontaktiert wird; und
(c) zumindest einmaliges Aussetzen des Fluides (22) in der Reinigungskammer (12) der Megaschallenergie-Übertragereinrichtung für einen Zeitraum, der ausreichend ist, die unerwünschten Partikel von dem Substrat (16) zu entfernen.

2. Verfahren nach Anspruch 1, bei dem das Gas aus einer Gruppe ausgewählt wird, die aus Kohlendioxid, Stickstoff, Stickstoffdioxid, Schwefelhexafluorid, und Xenon sowie Gemischen davon besteht.

3. Verfahren nach Anspruch 1, bei dem das Substrat zumindest eine Verunreinigung aus der folgenden Gruppe aufweist: polare organische Verunreinigungen, polare anorganische Verunreinigungen, unpolare organische Verunreinigungen mit einem niedrigen Molekulargewicht, und unpolare organische Verunreinigungen mit einem hohen Molekulargewicht, und der flüssige Modifizierer aus der folgenden Gruppe ausgewählt wird: (a) Isopropanol und Aceton zur Behandlung der polaren organischen Verunreinigungen, (b) Wasser zur Behandlung der polaren anorganischen Verunreinigungen, (c) Hexan zur Behandlung der unpolaren organischen Verunreinigungen mit niedrigem Molekulargewicht und (d) Kerosin zur Behandlung der unpolaren organischen Verunreinigungen mit hohen Molekulargewicht.

4. Verfahren nach Anspruch 1, bei dem das Substrat (16) organische Verunreinigungen aufweist, und das weiterhin, vor einem Kontaktieren des das unerwünschte Material enthaltenden Substrats (16) mit dem Fluid (22), den Schritt des Kontaktierens des Substrats (16) mit dem Gas in der dichten Phase bei einem Druck über den kritischen Druck des Gases und bei einer Temperatur über der kritischen Temperatur des Gases für einen Zeitraum, der ausreicht, um die organischen Verunreinigungen, welche in dem Gas in dieser dichten Phase lösbar sind, zu entfernen, aufweist.

5. Verfahren nach Anspruch 1, bei dem das Substrat (16) organische Verunreinigungen aufweist, und weiterhin, nach dem Aussetzungsschritt, den Schritt des Kontaktierens des Substrats (16) mit dem Gas in der dichten Phase bei einem Druck über dem kritischen Druck des Gases und einer Temperatur über der kritischen Temperatur des Gases für einen Zeitraum, der ausreichend ist, um die anorganischen Verunreinigungen, welche in dem Gas in dieser dichten Phase lösbar sind, zu entfernen, aufweist.

6. Verfahren nach Anspruch 1, das weiterhin, nach dem Aussetzungsschritt, den Schritt des Behandelns des die unerwünschten Partikel enthaltenden Fluides (22), um die unerwünschten Partikel zu entfernen, und des Zurückführens des behandelten Fluides (22) zu dem Reinigungsbehälter (12) aufweist.

7. Verfahren nach Anspruch 1, bei dem das Gas Kohlendioxid ist, und bei dem die Temperatur von ungefähr 10° bis ungefähr 30°C reicht und der Druck von ungefähr 600 bis 1,040 Pfund pro Quadratinch (ungefähr 42,2 bis 73,1 Kg/cm²) reicht.

8. Verfahren nach Anspruch 1, bei dem die Aussetzung für einen Zeitraum von mindestens ungefähr 1 Minute ausgeführt wird.

9. Verfahren nach Anspruch 1, bei dem die Übertragereinrichtung (20) eine Megaschallenergie mit einer Frequenz, die von mehr als ungefähr 110 bis 2,000 Kiloherz reicht, bereitstellt.

10. Vorrichtung (10) zum Entfernen der unerwünschten submikroner Partikel von der Hauptoberfläche des ausgewählten Substrats (16) in dem Verfahren nach Anspruch 1, mit:
(a) der Kammer (12), die das Fluid (22) und das die unerwünschten Partikel enthaltende Substrat (16) enthält, wobei die Kammer (12) mit
(1) der Einrichtung (18) zum Tragen des Substrats (16) in der Reinigungskammer (12), (2) der Megaschallenergie erzeugenden Übertragereinrichtung (20), und (3) der Einrichtung (18a) zum Ablenken der Megaschallenergie versehen ist;
(b) einer Drucksteuereinrichtung, die zum Steuern des Drucks in der Kammer (12) mit der Kammer (12) verbunden ist;
(c) einer Temperatursteuereinrichtung (46), die zum Steuern der Temperatur in der Kammer (12) mit der Kammer (12) verbunden ist;
(d) einer Einlaßeinrichtung (32) in der Kammer (12) zum Einbringen des Fluides (22) in die Kammer (12); und
(e) einer Auslaßeinrichtung (44) in der Kammer (12) zum Entfernen des Fluides (22) aus der Kammer (12).

## Revendications

1. Procédé pour éliminer des particules indésirables, inférieures au micromètre, d'une surface principale d'un substrat (16) choisi, qui comprend les étapes consistant :
(a) à mettre en place ce substrat (16) contenant les particules indésirables en question dans une chambre (12) de nettoyage équipée (1) d'un moyen (18) servant à supporter le substrat dans la chambre de nettoyage en question, (2) d'un moyen transducteur (20) produisant de l'énergie mégasonore, solidaire du moyen (18) de support du substrat et orienté de manière à émettre une énergie mégasonore parallèlement à la surface principale du substrat (16), et (3) d'un moyen (18a) permettant de dévier l'énergie mégasonore de manière à protéger cette énergie mégasonore d'une interférence destructive avec elle-même ;
(b) à introduire dans la chambre de nettoyage un fluide (22) choisi dans le groupe consistant en (1) un gaz liquéfié, (2) un mélange de gaz liquéfiés et (3) un gaz liquéfié contenant un modificateur liquide, ce fluide (22) étant formé sous une pression appliquée d'environ 600 à 3000 lb par in² (42,2 à 210,9 kg/cm²), à une température d'environ 50°C ou moins, et à mettre en contact ce substrat (16) contenant ces particules indésirables avec le fluide (22) en question à une température inférieure à la température critique du gaz concerné ; et
(c) à exposer au moins une fois ce fluide (22) dans la chambre de nettoyage (12) au moyen transducteur d'énergie mégasonore pendant une durée suffisante pour éliminer du substrat (16) les particules indésirables en question.

2. Procédé suivant la revendication 1, dans lequel le gaz est choisi dans le groupe consistant en l'anhydride carbonique, l'azote, le protoxyde d'azote, l'hexafluorure de soufre et le xénon, et des mélanges de ces gaz.

3. Procédé suivant la revendication 1, dans lequel le substrat porte au moins une impureté choisie dans le groupe consistant en impuretés organiques polaires, impuretés inorganiques polaires, impuretés organiques non polaires de bas poids moléculaire et impuretés organiques non polaires de haut poids moléculaire et le modificateur liquide est choisi dans le groupe consistant en (a) l'isopropanol et l'acétone pour le traitement des impuretés organiques polaires, b) l'eau pour le traitement des impuretés inorganiques polaires, (c) l'hexane pour le traitement des impuretés organiques non polaires de bas poids moléculaire et (d) le kérosène pour le traitement des impuretés organiques non polaires de haut poids moléculaire.

4. Procédé suivant la revendication 1, dans lequel le substrat (16) porte des impuretés organiques, et qui comprend en outre l'étape consistant, avant la mise en contact du substrat (16) contenant la matière indésirable avec le fluide (22), à mettre en contact le substrat (16) avec le gaz en phase dense à une pression supérieure à la pression critique du gaz et à une température au-dessus de la température critique du gaz pendant une durée suffisante pour éliminer les impuretés organiques qui sont solubles dans ce gaz en phase dense.

5. Procédé suivant la revendication 1, dans lequel le substrat (16) porte des impuretés organiques, et qui comprend en outre l'étape consistant, après l'étape d'exposition, à faire entrer le substrat (16) en contact avec le gaz en phase dense à une pression au-dessus de la pression critique du gaz et à une température au-dessus de la température critique du gaz pendant une durée suffisante pour éliminer les impuretés organiques qui sont solubles dans le gaz en phase dense.

6. Procédé suivant la revendication 1, qui comprend en outre l'étape consistant, après l'étape d'exposition, à traiter le fluide (22) contenant les particules indésirables pour éliminer ces dernières et à renvoyer le fluide traité (22) au récipient de nettoyage (12).

7. Procédé suivant la revendication 1, dans lequel le gaz en question est de l'anhydride carbonique et dans lequel la température varie d'environ 10 à environ 30°C et la pression va d'environ 600 à 1040 lb par in² (environ 42,2 à 73,1 kg/cm²).

8. Procédé suivant la revendication 1, dans lequel l'exposition est effectuée pendant une durée d'au moins 1 minute environ.

9. Procédé suivant la revendication 1, dans lequel le moyen transducteur (20) produit de l'énergie mégasonore d'une fréquence allant de plus d'environ 110 à 2000 kilohertz.

10. Appareil (10) pour éliminer lesdites particules indésirables de diamètre inférieur au micromètre de la surface principale du substrat (16) choisi dans le procédé suivant la revendication 1, comprenant :
(a) la chambre (12) destinée à contenir le fluide (22) et le substrat (16) portant les particules indésirables, cette chambre (12) étant équipée (1) du moyen (18) de support du substrat (16) dans la chambre de nettoyage (12), (2) du moyen transducteur (20) produisant de l'énergie mégasonore et (3) du moyen (18a) permettant de dévier l'énergie mégasonore ;
(b) un moyen de réglage de pression relié à la chambre (12) et servant à régler la pression à l'intérieur de la chambre (12) ;
(c) un moyen (46) de réglage de température relié à la chambre (12) et servant à régler la température à l'intérieur de la chambre (12) ;
(d) un moyen (32) d'admission dans la chambre (12) permettant d'introduire le fluide (22) dans cette chambre (12) ; et
(e) un moyen (44) d'échappement de la chambre (12) permettant au fluide (22) de sortir de la chambre (12).
